# EUROPÄISCHE PATENTSCHRIFT

(11) **EP 1 271 577 B1**
(45) Veröffentlichungstag und Bekanntmachung des Hinweises auf die Patenterteilung: **18.01.2006**
(21) Anmeldenummer: 01810570.0
(22) Anmeldetag: 13.06.2001
(51) Int. Cl.: H01G 2/04, H05K 7/02

(54) **Haltevorrichtung für ein elektronisches Bauelement**
Mounting device for an electronic component
Dispositif de montage pour un composant électronique

(43) Veröffentlichungstag der Anmeldung: 02.01.2003
(73) Patentinhaber: ABB Schweiz AG, 5400 Baden (CH)
(72) Erfinder: Rees, Jochen, 79761 Waldshut (DE)
(74) Vertreter: ABB Patent Attorneys

(56) Entgegenhaltungen:
- EP-A- 0 948 003
- WO-A-01/01549
- FR-A- 2 770 739
- GB-A- 826 457

## Beschreibung

### Technisches Gebiet

Die vorliegende Erfindung bezieht sich auf das Gebiet der Befestigungstechnik elektronischer Bauelemente. Sie betrifft eine Haltevorrichtung für mindestens ein elektronisches Bauelement gemäss dem Oberbegriff des unabhängigen Anspruchs.

### Stand der Technik

Elektronische Bauelemente, insbesondere Leistungswiderstände oder Leistungskondensatoren, werden heute in einer Fülle von leistungselektronischen Schaltungen, insbesondere in Stromrichterschaltungen, eingesetzt. Zur Befestigung des entsprechenden elektronischen Bauelements in der Stromrichterschaltung sind übliche Haltevorrichtungen vorgesehen. Eine solche Haltevorrichtung ist aus zwei im wesentlichen plattenförmigen Schenkeln aufgebaut, die an einem ihrer Schenkelenden miteinander verbunden sind. Die beiden Schenkel bilden dabei im wesentlichen einen rechten Winkel. Das Bauelement ist gängigerweise an seinen elektrischen Anschlüssen an einem der Schenkel befestigt. Der andere Schenkel dient der Befestigung der Haltevorrichtung beispielsweise an einem Rahmen einer Stromrichterschaltung und ist dazu mit entsprechenden Löchern versehen.

Eine weitere Haltevorrichtung für eine elektronisches Bauelement, insbesondere für einen Kondensator, ist in der FR2 770 739 angegeben. Darin ist die Haltevorrichtung aus einem im wesentlichen plattenförmigen Schenkel und aus einer Leiterplatte aufgebaut, wobei der Schenkel und die Leiterplatte an einem ihrer Enden miteinander verbunden sind und zueinander einen im wesentlichen rechten Winkel bilden. Der Schenkel und die Leiterplatte weisen jeweils eine dem im wesentlichen rechten Winkel zugewandte Innenwand auf, wobei die Schenkelinnenwand des Schenkels eine V-förmige Aufnahmefläche zur Auflage eines Mantelflächenteils des elektronischen Bauelementes aufweist. Weiterhin weist der Kondensator ein starres Federkontaktpaar als elektrische Anschlüsse auf, welches gegenüber der Leiterplatteninnenwand angeordnet ist und durch die Leiterplatte geführt ist und typischerweise auf der Rückseite der Leiterplatte festgelötet ist.

Problematisch bei einer derartigen Haltevorrichtung ist, dass das elektronische Bauelement nur an seinen elektrischen Anschlüssen mit der Haltevorrichtung verbunden ist. Bei mechanischen Beanspruchungen, insbesondere Biegebeanspruchungen auf das Bauelement, wie sie gängigerweise in einem rauen Umfeld in einer Stromrichterschaltung vorherrschen können, können die Anschlüsse des Bauelementes abreissen und damit das Bauelement und die Haltevorrichtung beschädigen oder zerstören. Weiterhin ist die Montage zum Austausch und Wartung des Bauelementes bei einer bereits in einer Stromrichterschaltung montierten Haltevorrichtung sehr schwierig, da das Bauelement nur an seinen Anschlüssen an der Haltevorrichtung befestigbar ist und sonst keinen weiteren Haltepunkt und/oder keine zusätzliche Haltefläche aufweist, welche eine Haltefunktion des Bauelementes bei der Montage und Wartung einnehmen könnte. Dadurch ist aber die Montage und die Wartung des Bauelementes aufwendig, langwierig und verursacht erhebliche Kosten.

### Darstellung der Erfindung

Aufgabe der Erfindung ist es deshalb, eine Haltevorrichtung für mindestens ein elektronisches Bauelement derart weiterzubilden, dass eine verbesserte Befestigung des Bauelementes in einer Schaltung, insbesondere einer Stromrichterschaltung erreicht wird sowie eine besonders einfache, schnelle und damit kostengünstige Montage und Wartung des Bauelementes ermöglicht wird. Diese Aufgabe wird durch die Merkmale des Anspruchs 1 gelöst. In den Unteransprüchen sind vorteilhafte Weiterbildungen der Erfindung angegeben.

Die erfindungsgemässe Haltevorrichtung für mindestens ein elektronisches Bauelement ist aus einem ersten im wesentlichen plattenförmigen Schenkel und aus einem zweiten im wesentlichen plattenförmigen Schenkel aufgebaut, wobei die beiden Schenkel an einem ihrer Schenkelenden miteinander verbunden sind und zueinander einen im wesentlichen rechten Winkel bilden. Erfindungsgemäss weisen der erste Schenkel und der zweite Schenkel jeweils eine dem im wesentlichen rechten Winkel zugewandte Schenkelinnenwand auf, wobei die Schenkelinnenwand des ersten Schenkels eine Aufnahmefläche zur Auflage eines Mantelflächenteils des elektronischen Bauelementes aufweist. Durch diese Aufnahmefläche ist vorteilhaft ein Haltepunkt, eine Haltelinie oder eine Haltefläche gegeben, auf der das Bauelement aufliegen kann und somit zusätzlichen Halt zu der üblichen Befestigung des Bauelements an seinen elektrischen Anschlüssen an einem der Schenkel, insbesondere am zweiten Schenkel, erfährt. Insgesamt erhält das Bauelement durch die Aufnahmefläche beispielsweise in einer Stromrichterschaltung eine verbesserte Fixierung. Weiterhin muss das Bauelement zu Montage- und/oder Wartungszwecken lediglich auf die Aufnahmefläche gelegt werden und kann dann schliesslich sehr einfach und schnell an seinen elektrischen Anschlüssen befestigt werden, so dass eine kostengünstige Wartung und/oder Montage erreicht werden kann.

Darüber hinaus weist die Schenkelinnenwand des zweiten Schenkels erfindungsgemäss mindestens eine Pressfläche zur flächigen Kontaktierung eines einen elektrischen Anschluss umfassenden Oberflächenteils des Bauelementes auf. Bei einer mechanischen Beanspruchung des Bauelementes, das gängigerweise an dem zweiten Schenkel mit seinen elektrischen Anschlüssen befestigt ist, ist das Bauelement mit dem Oberflächenteil durch die Anschlussbefestigung gegen die Pressfläche gepresst und somit zusätzlich fixiert, da annähernd kein Spiel zwischen der Pressfläche und dem Oberflächenteil des Bauelementes mit den elektrischen Anschlüssen vorliegt, so dass die elektrischen Anschlüsse vorteilhaft entlastet werden können. Die Lebensdauer des Bauelementes und der Haltevorrichtung kann vorteilhaft vergrössert werden, da die Haltevorrichtung und das Bauelement seltener durch Abriss der elektrischen Anschlüsse beschädigt oder gar zerstört werden.

Diese und weitere Aufgaben, Vorteile und Merkmale der vorliegenden Erfindung werden aus der nachfolgenden detaillierten Beschreibung bevorzugter Ausführungsbeispiele der Erfindung in Verbindung mit der Zeichnung offensichtlich.

### Kurze Beschreibung der Zeichnung

### Es zeigen:

- Fig. 1a: eine räumliche Darstellung einer ersten Ausführungsform einer erfindungsgemässen Haltevorrichtung für mindestens ein elektrisches Bauelement,
- Fig. 1b: eine Schnittdarstellung entlang lb-lb der ersten Ausführungsform der Haltevorrichtung gemäss Fig. 1a,
- Fig. 1c: eine Vorderansicht der ersten Ausführungsform der Haltevorrichtung gemäss Fig. 1a,
- Fig. 2a: eine räumliche Teilausschnittdarstellung einer zweiten Ausführungsform der erfindungsgemässen Haltevorrichtung für mindestens ein elektrisches Bauelement und
- Fig. 2b: eine Vorderansicht der zweiten Ausführungsform der Haltevorrichtung gemäss Fig. 2a.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebenen Ausführungsformen stehen beispielhaft für den Erfindungsgegenstand und haben keine beschränkende Wirkung.

### Wege zur Ausführung der Erfindung

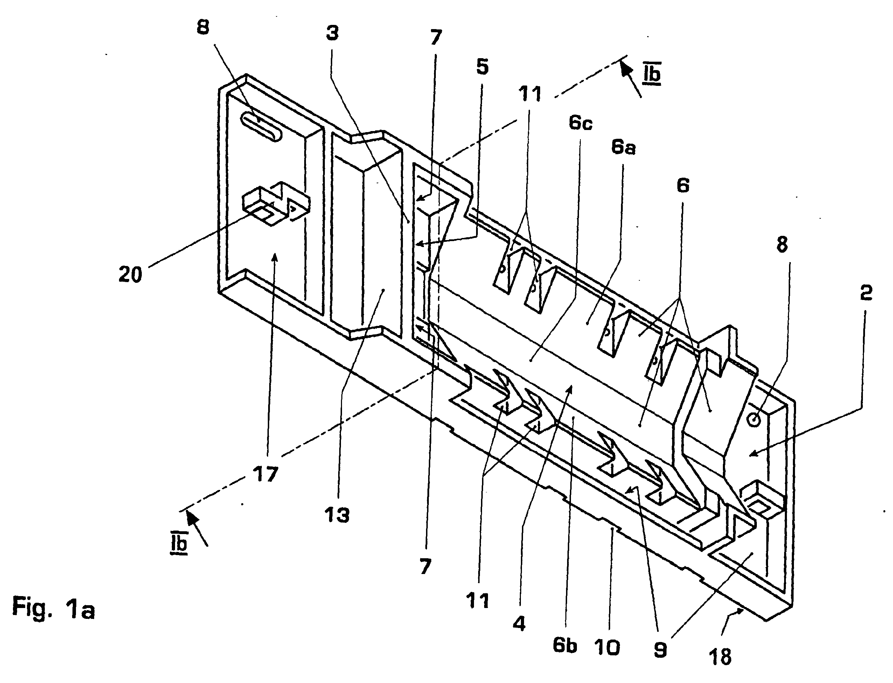

In Fig. 1a ist eine räumliche Darstellung einer ersten Ausführungsform einer erfindungsgemässen Haltevorrichtung für mindestens ein elektrisches Bauelement 1, insbesondere für einen Leistungswiderstand oder Leistungskondensator, dargestellt. Das elektronische Bauelement 1 ist der Übersichtlichkeit halber in Fig. 1a nicht gezeigt. Die erfindungsgemässe Haltevorrichtung ist gemäss Fig. 1a aus einem ersten Schenkel 2 und aus einem zweiten Schenkel 3 aufgebaut. Der erste Schenkel 2 und der zweite Schenkel 3 sind im wesentlichen plattenförmig ausgebildet, wobei die beiden Schenkel 2, 3 an einem ihrer Schenkelenden miteinander verbunden sind. Dabei sind die beiden Schenkel 2, 3 derart angeordnet, dass sie zueinander einen im wesentlichen rechten Winkel bilden.

Erfindungsgemäss weisen der erste Schenkel 2 und der zweite Schenkel 3 jeweils eine dem im wesentlichen rechten Winkel zugewandte Schenkelinnenwand 4, 5 auf, wobei die Schenkelinnenwand 4 des ersten Schenkels 2 eine Aufnahmefläche 6 zur Auflage eines Mantelflächenteils des elektronischen Bauelementes 1 aufweist. Die Aufnahmefläche 6 stellt vorteilhaft einen Haltepunkt beziehungsweise eine Haltefläche für das elektronische Bauelement 1 dar, auf der das Bauelement 1 aufliegen kann. Die Aufnahmefläche 6 bietet dem Bauelement 1 somit zusätzlichen Halt zu der üblichen aus dem Stand der Technik bekannten Befestigung an seinen elektrischen Anschlüssen an einem der Schenkel 2, 3, insbesondere am zweiten Schenkel 3.

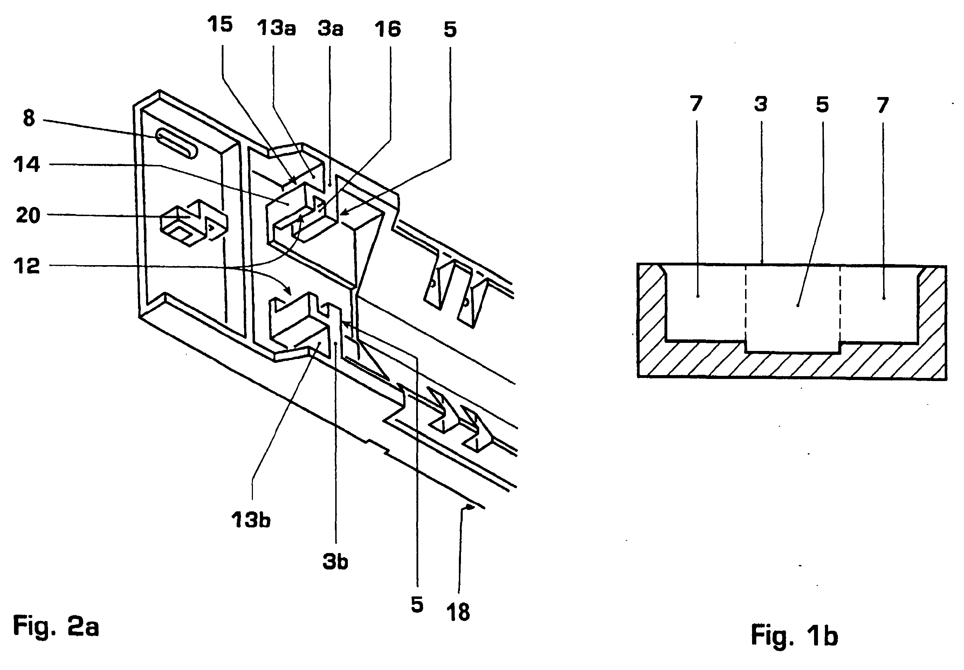

In Fig. 1b ist eine Schnittdarstellung entlang Ib-Ib der ersten Ausführungsform der Haltevorrichtung gemäss Fig. 1a gezeigt. Erfindungsgemäss weist der zweite Schenkel 3 gemäss Fig. 1a und Fig. 1b an seiner Schenkelinnenwand 5 mindestens eine Pressfläche 7 zur flächigen Kontaktierung eines einen elektrischen Anschluss umfassenden Oberflächenteils des Bauelementes 1 auf. Das Bauelement 1 ist mit dem Oberflächenteil durch die Befestigung an seinen elektrischen Anschlüssen am zweiten Schenkel 2 gegen die Pressfläche 7 gepresst, so dass das Bauelement 1 bei mechanischen Beanspruchungen zusätzlich fixiert werden kann, da annähernd kein Spiel zwischen der Pressfläche 7 und dem Oberflächenteil des Bauelementes mit den elektrischen Anschlüssen vorliegt. Vorteilhaft werden die elektrischen Anschlüsse des Bauelementes 1 entlastet, wodurch die Lebensdauer des Bauelementes 1 und der Haltevorrichtung vergrössert werden kann, da die Haltevorrichtung und das Bauelement 1 seltener durch Abriss der elektrischen Anschlüsse beschädigt oder gar zerstört werden.

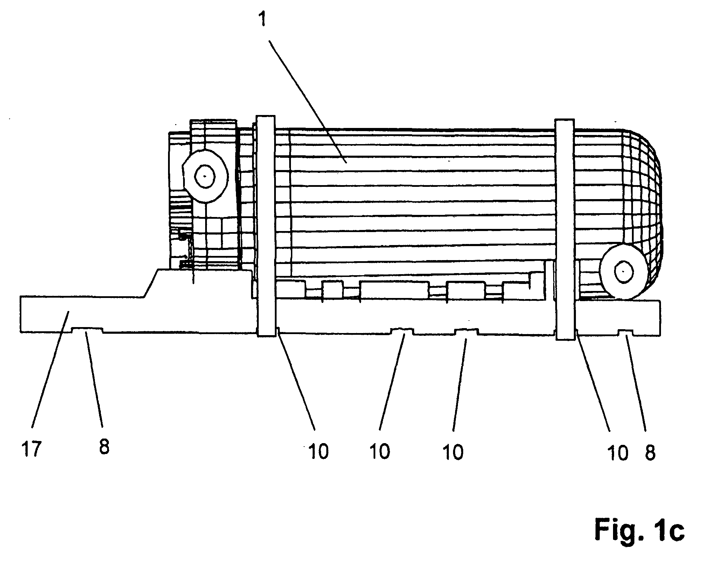

In Fig. 1c ist eine Vorderansicht der ersten Ausführungsform der Haltevorrichtung gemäss Fig. 1a dargestellt, wobei in Fig. 1c zusätzlich für das elektronische Bauelement 1 beispielhaft ein Leistungswiderstand gezeigt ist. Gemäss Fig. 1a weist die Schenkelinnenwand 4 des ersten Schenkels 2 einen Randbereich 9 auf, wobei sich die Aufnahmefläche 6 bis an den Randbereich 9 erstreckt. Demnach erstreckt sich der Randbereich 9 von der Aufnahmefläche 9 bis zum Rand des ersten Schenkels 2. In diesem Randbereich 9 sind senkrecht zur Schenkelinnenwand 4 des ersten Schenkels 2 mindestens zwei jeweils von der Schenkelinnenwand 4 des ersten Schenkels 2 zu einer der Schenkelinnenwand 4 gegenüberliegenden Schenkelaussenwand 18 des ersten Schenkels 2 verlaufende Montagelöcher 8 vorgesehen. Mittels dieser Montagelöcher 8 ist es möglich, die Haltevorrichtung sehr einfach an einem Rahmen beispielsweise einer Stromrichterschaltung zu montieren. Weiterhin sind im Randbereich 9 senkrecht zur Schenkelinnenwand 4 des ersten Schenkels 2 mindestens zwei jeweils von der Schenkelinnenwand 4 des ersten Schenkels 2 zu einer der Schenkelinnenwand 4 gegenüberliegenden Schenkelaussenwand 18 des ersten Schenkels 2 verlaufende Löcher 10 vorgesehen. Durch die Löcher 10 können Verzurrbänder gemäss Fig. 1c, insbesondere Kabelbinder, geschleift werden, die um das Bauelement gelegt sind und dieses durch Festziehen und anschliessendes Festbinden gegen die Aufnahmefläche 6 pressen. Eine weitere Verbesserung der Montage der Haltevorrichtung an einem Rahmen einer Stromrichterschaltung kann dadurch erzielt werden, dass an der Verbindung des ersten Schenkels 2 mit dem zweiten Schenkel 3 eine sich bezüglich des ersten Schenkels 2 in entgegengesetzter Richtung fluchtend erstreckende Fortsatzplatte 17 angeordnet ist, wobei mindestens ein senkrecht durch die Fortsatzplatte 17 verlaufendes weiteres Montageloch 8 vorgesehen ist, an welchem die Haltevorrichtung zusätzlich befestigt werden kann.

Femer weist die Aufnahmefläche 6 gemäss Fig. 1a erfindungsgemäss einen ersten Flächenteil 6a und einen zweiten Flächenteil 6b auf, wobei sich die beiden Flächenteile 6a, 6b jeweils im wesentlichen in einer Flächenteilverlaufsrichtung erstrecken. Dabei ist die Flächenteilverlaufsrichtung als Richtung definiert, welche von der Verbindung des ersten Schenkels 2 mit dem zweiten Schenkel 3 bis zum fluchtend gegenüberliegenden Schenkelende des ersten Schenkels 1 zeigt, wie in Fig. 1a eingezeichnet. In senkrechter Richtung zur Flächenteilverlaufsrichtung steigen der erste Flächenteil 6a und der zweite Flächenteil 6b gemäss Fig. 1a dachartig bis zum Randbereich 9 hin an, wobei sich die beiden Flächenteile 6a, 6b gegenüberliegen. Dadurch erhalten zylinderförmige Bauelemente 1 mit einem im wesentlichen kreisförmigen Querschnitt, wie in Fig. 1c dargestellt, vorteilhaft eine grössere Haltefläche, so dass die Haltefunktion der Aufnahmefläche 6 verbessert werden kann. Eine weitere Vergrösserung der Haltefläche kann vorteilhaft dadurch erreicht werden, dass die Aufnahmefläche 6 gemäss Fig. 1a einen dritten Flächenteil 6c aufweist, der sich im wesentlichen in der vorstehend definierten Flächenteilverlaufsrichtung zwischen dem ersten Flächenteil 6a und dem zweiten Flächenteil 6b erstreckt.

Darüber hinaus weisen der erste Flächenteil 6a und der zweite Flächenteil 6b der Aufnahmefläche 6 nach Fig. 1a erfindungsgemäss senkrecht zur Flächenteilverlaufsrichtung verlaufende Nuten 11 auf. Jeweils einer Nut 11 des ersten Flächenteils 6a liegt eine Nut 11 des zweiten Flächenteils 6b fluchtend gegenüber. In die jeweils gegenüberliegenden Nuten 11 können der Übersichtlichkeit halber in Fig. 1a nicht gezeigte Distanzelemente je nach Grösse des Bauelementes 1 eingesteckt werden, die ein Verrutschen des Bauelementes 1 in Flächenteilverlaufsrichtung verunmöglichen und gleichzeitig gewährleisten, dass das Bauelement 1 weiter gegen die Pressfläche 7 gepresst ist.

In Fig. 2a ist eine räumliche Teilausschnittdarstellung einer zweiten Ausführungsform der erfindungsgemässen Haltevorrichtung für mindestens ein elektrisches Bauelement 1 dargestellt, die sich von der vorstehend beschriebenen erfindungsgemässen ersten Ausführungsform gemäss Fig. 1a, Fig. 1b und Fig. 1c dadurch unterscheidet, dass der zweite Schenkel 3 eine sich im wesentlichen von der Verbindung des ersten Schenkels 2 mit dem zweiten Schenkel 3 zum fluchtend gegenüberliegenden Schenkelende des zweiten Schenkels 3 erstreckende Aussparung 12 aufweist. Die Aussparung 12 ist als Durchführung von der Schenkelinnenwand 5 des zweiten Schenkels 3 zu einer der Schenkelinnenwand 5 gegenüberliegenden Schenkelaussenwand 13 des zweiten Schenkels 3 ausgebildet und teilt den zweiten Schenkel 3 gemäss Fig. 2a in zwei Teilschenkel 3a, 3b auf. Anschlusskabel an den elektrischen Anschlüssen des Bauelementes, welche der Übersichtlichkeit halber nicht dargestellt sind, können durch die Aussparung 12 so sehr einfach und auf einem kurzen Weg von der Haltevorrichtung weggeführt werden, so dass vorteilhaft wenig Anschlusskabelmaterial benötigt wird. Die, erste Ausführungsform der erfindungsgemässen Haltevorrichtung nach Fig. 1a und die zweite Ausführungsform der erfindungsgemässen Haltevorrichtung nach Fig. 2a weist eine Anschlusskabelbefestigungseinrichtung 20 auf, die auf der dem zweiten Schenkel 3 zugewandten Seite der Fortsatzplatte 17 vorgesehen ist. Vorzugsweise Anschlusskabelbefestigungseinrichtung 20 laschenförmig ausgebildet, so das die Anschlusskabel mit Verzurrbänder, insbesondere Kabelbinder, welche durch die Anschlusskabelbefestigungseinrichtung 20 geschleift sind, an der Anschlusskabelbefestigungseinrichtung 20 festgebunden werden können. Die elektrischen Anschlüsse des können somit vorteilhaft vor mechanischen Einwirkungen über die Anschlusskabel geschützt werden

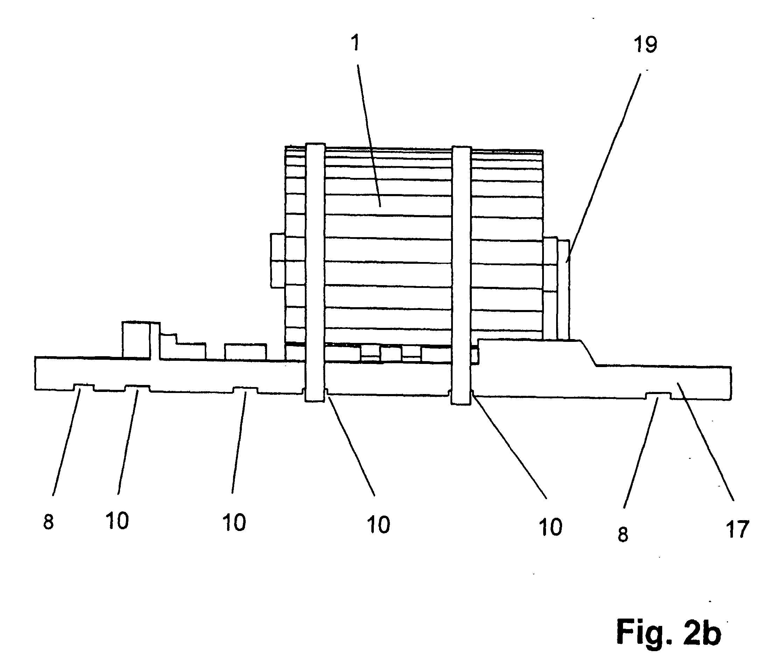

Da der zweite Schenkel 3 in zwei Teilschenkel 3a, 3b in vorstehend beschriebener Weise aufgeteilt ist, sind die Schenkelinnenwand 5 und die Schenkelaussenwand 13 des zweiten Schenkels 3 entsprechend in jeweils eine Schenkelinnenwand des zugehörigen Teilschenkels 3a, 3b und in eine Schenkelaussenwand 13a, 13b des zugehörigen Teilschenkels 3a, 3b aufgeteilt. Weiterhin ist an der Schenkelaussenwand 13a, 13b eines jeden Teilschenkels 3a, 3b gemäss Fig. 2a ein Element 14 vorgesehen, das winkelförmig ausgebildet ist. Das winkelförmige Element 14 bildet mit einem Teil der Schenkelaussenwand 13a, 13b des zugehörigen Teilschenkels 3a, 3b eine Aufnahmeeinrichtung 15 für eine Bauelementhalteschiene 19. In Fig. 2b ist eine solche Bauelementhalteschiene 19 in einer Vorderansicht der zweiten Ausführungsform der Haltevorrichtung gemäss Fig. 2a dargestellt, wobei in Fig. 2b zusätzlich für das elektronische Bauelement 1 beispielhaft ein Leistungskondensator mit einem kreisförmigen Querschnitt und jeweils einem elektrischen Anschluss auf jeder Stimseite gezeigt ist. Die Aufnahmeeinrichtung 15 weist gemäss Fig. 2a eine längs der Schenkelaussenwand 13a, 13b des zugehörigen Teilschenkels 3a, 3b bis zur Verbindung des ersten Schenkels 2 mit dem jeweiligen Teilschenkel 3a, 3b verlaufende Vertiefung 16 auf. Vorzugsweise ist die Vertiefung 16 zur Aussparung 12 hin offen, so dass die Bauelementhalteschiene 19 in die jeweilige Vertiefung einsteckbar ist und ohne weitere Befestigung auskommt. Gemäss Fig. 2b ist der Leistungskondensator mit durch die Löcher 10 geschleiften und um den Leistungskondensator gelegten und festgebundenen Kabelbindern gegen die Aufnahmefläche 6 gepresst. Der Leistungskondensator ist mit einem seiner elektrischen Anschlüsse mit der Bauelementhalteschiene 19 verbunden und erhält somit vorteilhaft zusätzlichen Halt. Die efindungsgemässe Haltevorrichtung kann vorteilhaft mehrere elektronische Bauelemente 1, insbesondere Leistungskondensatoren, aufnehmen, wobei die elektronischen Bauelemente in Reihe auf der Aufnahmefläche aufliegen und vorzugsweise jeweils mit Verzurrbändem, insbesondere Kabelbindern, in vorstehend beschriebener Weise gegen die Aufnahmefläche 6 gepresst sind.

Die erfindungsgemässe Haltevorrichtung ist vorteilhaft aus einem giessfähigen Isolationsmaterial aufgebaut, wodurch sich die beiden Schenkel 2, 3 und die weiteren vorstehend beschriebenen Komponenten der Haltevorrichtung problemlos realisieren lassen, ohne dass eine spanende Bearbeitung wie insbesondere Fräsen und/oder Schleifen nötig ist.

Insgesamt ist mit der erfindungsgemässen Halteeinrichtung eine verbesserte Befestigung des elektronischen Bauelementes 1 in einer Schaltung, insbesondere einer Stromrichterschaltung erreichbar, wobei zudem eine besonders einfache, schnelle und damit kostengünstige Montage und Wartung des Bauelementes 1 erzielt werden kann.

### Bezugszeichenliste

- 1: elektronisches Bauelement
- 2: erster Schenkel
- 3: zweiter Schenkel
- 3a, 3b: Teilschenkel
- 4: Schenkelinnenwand des ersten Schenkels
- 5: Schenkelinnenwand des zweiten Schenkels
- 6: Aufnahmefläche
- 6a: erstes Flächenteil
- 6b: zweites Flächenteil
- 6c: drittes Flächenteil
- 7: Pressfläche
- 8: Montageloch
- 9: Randbereich
- 10: Löcher
- 11: Nut
- 12: Aussparung .
- 13: Schenkelaussenwand des zweiten Schenkels
- 13a, 13b: Schenkelaussenwand des Teilschenkels
- 14: Element
- 15: Aufnahmeeinrichtung
- 16: Vertiefung
- 17: Fortsatzplatte
- 18: Schenkelaussenwand des ersten Schenkels
- 19: Bauteilhalteschiene
- 20: Anschlusskabelbefestigungseinrichtung

## Patentansprüche

1. Haltevorrichtung für mindestens ein elektronisches Bauelement (1), die aus einem ersten im wesentlichen plattenförmigen Schenkel (2) und aus einem zweiten im wesentlichen plattenförmigen Schenkel (3) aufgebaut ist,
die beiden Schenkel (2; 3) an einem ihrer Schenkelenden miteinander verbunden sind und zueinander einen im wesentlichen rechten Winkel bilden,
der erste Schenkel (2) und der zweite Schenkel (3) jeweils eine dem im wesentlichen rechten Winkel zugewandte Schenkelinnenwand (4; 5) aufweisen, und
die Schenkelinnenwand (4) des ersten Schenkels (2) eine Aufnahmefläche (6) zur Auflage eines Mantelflächenteils des elektronischen Bauelementes (1) aufweist,
**dadurch gekennzeichnet,**
**dass** die Schenkelinnenwand (5) des zweiten Schenkels (3) mindestens eine Pressfläche (7) zur flächigen Kontaktierung eines einen elektrischen Anschluss umfassenden Oberflächenteils des Bauelementes (1) aufweist.

2. Haltevorrichtung nach Anspruch 1, **dadurch gekennzeichnet, dass** an der Verbindung des ersten Schenkels (2) mit dem zweiten Schenkel (3) eine sich bezüglich des ersten Schenkels (1) in entgegengesetzter Richtung fluchtend erstreckende Fortsatzplatte (17) angeordnet ist, wobei mindestens ein senkrecht durch die Fortsatzplatte (17) verlaufendes Montageloch (8) vorgesehen ist.

3. Haltevorrichtung nach Anspruch 2, **dadurch gekennzeichnet, dass** auf der dem zweiten Schenkel (3) zugewandten Seite der Fortsatzplatte (17) eine Anschlusskabelbefestigungseinrichtung (20) vorgesehen ist.

4. Haltevorrichtung nach einem der Ansprüche 1 bis 3, **dadurch gekennzeichnet, dass** die Schenkelinnenwand (4) des ersten Schenkels (2) einen Randbereich (9) aufweist und dass sich die Aufnahmefläche (6) bis an den Randbereich (9) erstreckt.

5. Haltevorrichtung nach Anspruch 4, **dadurch gekennzeichnet, dass** im Randbereich (9) senkrecht zur Schenkelinnenwand (4) des ersten Schenkels (2) mindestens zwei jeweils von der Schenkelinnenwand (4) des ersten Schenkels (2) zu einer Schenkelaussenwand (18) des ersten Schenkels (2) verlaufende Löcher (10) vorgesehen sind.

6. Haltevorrichtung nach Anspruch 4, **dadurch gekennzeichnet, dass** im Randbereich (9) senkrecht zur Schenkelinnenwand (4) des ersten Schenkels (2) mindestens zwei jeweils von der Schenkelinnenwand (4) des ersten Schenkels (2) zu einer Schenkelaussenwand (18) des ersten Schenkels (2) Montagelöcher (8) vorgesehen sind.

7. Haltevorrichtung nach Anspruch 4, **dadurch gekennzeichnet, dass** die Aufnahmefläche (6) einen ersten Flächenteil (6a) und einen zweiten Flächenteil (6b) aufweist, und dass sich die beiden Flächenteile (6a; 6b) jeweils im wesentlichen in einer Flächenteilverlaufsrichtung erstrecken, wobei die Flächenteilverlaufsrichtung als Richtung definiert ist, welche von der Verbindung des ersten Schenkels (2) mit dem zweiten Schenkel (3) zum fluchtend gegenüberliegenden Schenkelende des ersten Schenkels (2) zeigt.

8. Haltevorrichtung nach Anspruch 7, **dadurch gekennzeichnet, dass** der erste Flächenteil (6a) und der zweite Flächenteil (6b) senkrecht zur Flächenteilverlaufsrichtung dachartig bis zum Randbereich (9) hin ansteigen.

9. Haltevorrichtung nach Anspruch 7 oder 8, **dadurch gekennzeichnet, dass** der erste Flächenteil (6a) und der zweite Flächenteil (6b) senkrecht zur Flächenteilverlaufsrichtung verlaufende Nuten (11) aufweisen.

10. Haltevorrichtung nach Anspruch 9, **dadurch gekennzeichnet, dass** jeweils einer Nut (11) des ersten Flächenteils (6a) eine Nut (11) des zweiten Flächenteils (6b) fluchtend gegenüberliegt.

11. Haltevorrichtung nach einem der Ansprüche 7 bis 10, **dadurch gekennzeichnet, dass** die Aufnahmefläche (6) einen dritten Flächenteil (6c) aufweist, der sich im wesentlichen in Flächenteilverlaufsrichtung zwischen dem ersten Flächenteil (6a) und dem zweiten Flächenteil (6b) erstreckt.

12. Haltevorrichtung nach einem der vorhergehenden Ansprüche, **dadurch gekennzeichnet, dass** der zweite Schenkel (3) eine sich im wesentlichen von der Verbindung des ersten Schenkels (2) mit dem zweiten Schenkel (3) zum fluchtend gegenüberliegenden Schenkelende des zweiten Schenkels (3) erstreckende Aussparung (12) aufweist.

13. Haltevorrichtung nach Anspruch 12, **dadurch gekennzeichnet, dass** die Aussparung (12) als Durchführung von der Schenkelinnenwand (5) des zweiten Schenkels (3) zu einer Schenkelaussenwand (13) des zweiten Schenkels (3) ausgebildet ist und den zweiten Schenkel (3) in zwei Teilschenkel (3a; 3b) aufteilt.

14. Haltevorrichtung nach Anspruch 13, **dadurch gekennzeichnet, dass** an einer Schenkelaussenwand (13a; 13b) eines jeden Teilschenkels (3a; 3b) ein Element (14) vorgesehen ist, das mit einem Teil der Schenkelaussenwand (13a; 13b) des zugehörigen Teilschenkels (3a; 3b) eine Aufnahmeeinrichtung (15) für eine Bauelementhalteschiene (19) bildet.

15. Haltevorrichtung nach Anspruch 14, **dadurch gekennzeichnet, dass** die Aufnahmeeinrichtung (15) eine längs der Schenkelaussenwand (13a; 13b) des zugehörigen Teilschenkels (3a; 3b) bis zur Verbindung des ersten Schenkels (2) mit dem jeweiligen Teilschenkel (3a; 3b) verlaufende Vertiefung (16) aufweist, wobei die Vertiefung (16) zur Aussparung (12) hin offen ist.

## Claims

1. Holding device for at least one electronic component (1) which is made up of a first substantially plate-shaped leg (2) and a second substantially plate-shaped leg (3),
the two legs (2; 3) are connected to each other at one of their leg ends and form in relation to each other a substantially orthogonal angle,
the first leg (2) and the second leg (3) in each case have a leg inner wall (4; 5) facing the substantially orthogonal angle, and
the leg inner wall (4) of the first leg (2) has a receiving surface (6) for the resting of a lateral surface part of the electronic component (1),
**characterized in that**
the leg inner wall (5) of the second leg (3) has at least one pressing surface (7) for the surface-area contacting of a surface part of the component (1) comprising an electrical terminal.

2. Holding device according to Claim 1, **characterized in that** a continuation plate (17), extending in line in the opposite direction with respect to the first leg (2), is arranged at the joint of the first leg (2) with the second leg (3), at least one mounting hole (8), running perpendicularly through the continuation plate (17), being provided.

3. Holding device according to Claim 2, **characterized in that** a connection-cable fastening device (20) is provided on the side of the continuation plate (17) facing the second leg (3).

4. Holding device according to one of Claims 1 to 3, **characterized in that** the leg inner wall (4) of the first leg (2) has an edge region (9) and **in that** the receiving surface (6) extends up to the edge region (9):

5. Holding device according to Claim 4, **characterized in that** provided in the edge region (9), perpendicularly to the leg inner wall (4) of the first leg (2), are at least two holes (10), which in each case run from the leg inner wall (4) of the first leg (2) to a leg outer wall (18) of the first leg (2).

6. Holding device according to Claim 4, **characterized in that** provided in the edge region (9), perpendicularly to the leg inner wall (4) of the first leg (2), are at least two mounting holes (8), which in each case run from the leg inner wall (4) of the first leg (2) to a leg outer wall (18) of the first leg (2).

7. Holding device according to Claim 4, **characterized in that** the receiving surface (6) has a first surface part (6a) and a second surface part (6b), and **in that** the two surface parts (6a; 6b) extend in each case substantially in a surface-part running direction, the surface-part running direction being defined as the direction which points from the joint of the first leg (2) with the second leg (3) to the in-line opposite leg end of the first leg (2).

8. Holding device according to Claim 7, **characterized in that** the first surface part (6a) and the second surface part (6b) rise in a roof-like manner towards the edge region (9), perpendicularly to the surface-part running direction.

9. Holding device according to Claim 7 or 8, **characterized in that** the first surface part (6a) and the second surface part (6b) have grooves (11) running perpendicularly to the surface-part running direction.

10. Holding device according to Claim 9, **characterized in that** opposite and in line with a groove (11) of the first surface part (6a) there respectively lies a groove (11) of the second surface part (6b).

11. Holding device according to one of Claims 7 to 10, **characterized in that** the receiving surface (6) has a third surface part (6c), which extends substantially in the surface-part running direction between the first surface part (6a) and the second surface part (6b).

12. Holding device according to one of the preceding claims, **characterized in that** the second leg (3) has a clearance (12) extending substantially from the joint of the first leg (2) with the second leg (3) to the in-line opposite leg end of the second leg (3).

13. Holding device according to Claim 12, **characterized in that** the clearance (12) is formed as a lead-through from the leg inner wall (5) of the second leg (3) to a leg outer wall (13) of the second leg (3) and divides the second leg (3) into two part-legs (3a; 3b).

14. Holding device according to Claim 13, **characterized in that** an element 14 which forms with part of the leg outer wall (13a; 13b) of the associated part-leg (3a; 3b) a receiving device (15) for a component holding rail (19) is provided on a leg outer wall (13a; 13b) of each part-leg (3a; 3b).

15. Holding device according to Claim 14, **characterized in that** the receiving device (15) has a depression (16) running along the leg outer wall (13a; 13b) of the associated part-leg (3a; 3b) up to the joint of the first leg (2) with the respective part-leg (3a; 3b), the depression (16) being open towards the clearance (12).

## Revendications

1. Dispositif de montage pour au moins un composant électronique (1), constitué d'une première branche (2) essentiellement en forme de plaque et d'une deuxième branche (3) essentiellement en forme de plaque,
les deux branches (2 ; 3) étant connectées l'une à l'autre à l'une de leurs extrémités de branches et formant ensemble un angle essentiellement droit,
la première branche (2) et la deuxième branche (3) présentant à chaque fois une paroi intérieure de branche (4 ; 5) tournée vers l'angle essentiellement droit, et
la paroi intérieure de branche (4) de la première branche (2) présentant une surface de logement (6) pour supporter une partie de surface d'enveloppe du composant électronique (1),
**caractérisé en ce que**
la paroi intérieure de branche (5) de la deuxième branche (3) présente au moins une surface de pression (7) pour la mise en contact à plat d'une partie de surface du composant (1) comprenant un raccord électrique.

2. Dispositif de montage selon la revendication 1, **caractérisé en ce que** l'on prévoit sur la connexion de la première branche (2) à la deuxième branche (3) une plaque avancée (17) s'étendant en affleurement dans la direction opposée par rapport à la première branche (2), au moins un trou de montage (8) s'étendant perpendiculairement à travers la plaque avancée (17) étant prévu.

3. Dispositif de montage selon la revendication 2, **caractérisé en ce que** l'on prévoit du côté de la plaque avancée (17) tourné vers la deuxième branche (3) un dispositif de fixation de câble de raccordement (20).

4. Dispositif de montage selon l'une quelconque des revendications 1 à 3, **caractérisé en ce que** la paroi intérieure de branche (4) de la première branche (2) présente une région de bord (9) et **en ce que** la surface de logement (6) s'étend jusqu'à la région de bord (9).

5. Dispositif de montage selon la revendication 4, **caractérisé en ce que** l'on prévoit dans la région de bord (9) perpendiculairement à la paroi intérieure de branche (4) de la première branche (2) au moins deux trous (10) s'étendant respectivement de la paroi intérieure de branche (4) de la première branche (2) jusqu'à une paroi extérieure de branche (18) de la première branche (2).

6. Dispositif de montage selon la revendication 4, **caractérisé en ce que** dans la région de bord (9) perpendiculairement à la paroi intérieure de branche (4) de la première branche (2) on prévoit au moins deux trous de montage (8) s'étendant respectivement de la paroi intérieure de branche (4) de la première branche (2) jusqu'à une paroi extérieure de branche (18) de la première branche (2).

7. Dispositif de montage selon la revendication 4, **caractérisé en ce que** la surface de logement (6) présente une première partie de surface (6a) et une deuxième partie de surface (6b), et **en ce que** les deux parties de surface (6a ; 6b) s'étendent à chaque fois dans une direction d'étendue de partie de surface, la direction d'étendue de partie de surface étant définie comme la direction qui va de la connexion de la première branche (2) à la deuxième branche (3) jusqu'à l'extrémité de branche opposée en affleurement de la première branche (2).

8. Dispositif de montage selon la revendication 7, **caractérisé en ce que** la première partie de surface (6a) et la deuxième partie de surface (6b) montent perpendiculairement à la direction d'étendue de partie de surface en forme de toit jusqu'à la région de bord (9).

9. Dispositif de montage selon la revendication 7 ou 8, **caractérisé en ce que** la première partie de surface (6a) et la deuxième partie de surface (6b) présentent des rainures (11) s'étendant perpendiculairement à la direction d'étendue de partie de surface.

10. Dispositif de montage selon la revendication 9, **caractérisé en ce qu'**à chaque fois une rainure (11) de la deuxième partie de surface (6b) est opposée en affleurement à une rainure respective (11) de la première partie de surface (6a).

11. Dispositif de montage selon l'une quelconque des revendications 7 à 10, **caractérisé en ce que** la surface de logement (6) présente une troisième partie de surface (6c) qui s'étend essentiellement dans la direction d'étendue de partie de surface entre la première partie de surface (6a) et la deuxième partie de surface (6b).

12. Dispositif de montage selon l'une quelconque des revendications précédentes, **caractérisé en ce que** la deuxième branche (3) présente un évidement (12) s'étendant essentiellement depuis la connexion de la première branche (2) à la deuxième branche (3) jusqu'à l'extrémité de branche opposée en affleurement de la deuxième branche (3).

13. Dispositif de montage selon la revendication 12, **caractérisé en ce que** l'évidement (12) est réalisé sous forme de passage de la paroi intérieure de branche (5) de la deuxième branche (3) à une paroi extérieure de branche (13) de la deuxième branche (3) et divise la deuxième branche (3) en deux branches partielles (3a ; 3b).

14. Dispositif de montage selon la revendication 13, **caractérisé en ce que** l'on prévoit sur une paroi extérieure de branche (13a ; 13b) de chaque branche partielle (3a ; 3b) un élément (14) qui forme avec une partie de la paroi extérieure de branche (13a ; 13b) de la branche partielle associée (3a ; 3b) un dispositif de logement (15) pour un rail de montage de composant (19).

15. Dispositif de montage selon la revendication 14, **caractérisé en ce que** le dispositif de logement (15) présente un renfoncement (16) s'étendant le long de la paroi extérieure de branche (13a ; 13b) de la branche partielle associée (3a ; 3b) jusqu'à la connexion de la première branche (2) à la branche partielle respective (3a ; 3b), le renfoncement (16) étant ouvert vers l'évidement (12).
